(19) **Europäisches Patentamt**

**European Patent Office**

**Office européen des brevets**

(11) **EP 0 971 394 A1**

(12) **EUROPEAN PATENT APPLICATION**
published in accordance with Art. 158(3) EPC

(43) Date of publication:
**12.01.2000 Bulletin 2000/02**

(21) Application number: **98936742.0**

(22) Date of filing: **11.08.1998**

(51) Int. Cl.[7]: **H01L 21/20**, H01L 21/203,
H01L 21/205, H01L 21/336,
H01L 29/73, H01L 29/78,
H01L 21/331, H01L 29/739

(86) International application number:
**PCT/JP98/03577**

(87) International publication number:
**WO 99/09585 (25.02.1999 Gazette 1999/08)**

(84) Designated Contracting States:
**DE FR GB SE**

(30) Priority: **13.08.1997 JP 21838897**

(71) Applicant:
**Matsushita Electric Industrial Co., Ltd.
Kadoma-shi, Osaka 571-8501 (JP)**

(72) Inventor: **KITABATAKE, Makoto
Nara-shi, Nara 631-0076 (JP)**

(74) Representative:
**Barnfather, Karl Jon, Dr. et al
Withers & Rogers,
Goldings House,
2 Hays Lane
London SE1 2HW (GB)**

(54) **SEMICONDUCTOR SUBSTRATE AND SEMICONDUCTOR DEVICE**

(57) A MOS transistor is composed of a semiconductor substrate 11 in which a Si thin film 13 is heteroepitaxially grown on a surface of an SiC substrate 12. A source electrode 38 and a drain electrode 34 are so provided that the above SiC substrate 12 is disposed in an output current path. According to this construction, a semiconductor device with a high dielectric strength and current-carrying capacity is achieved.

FIG. 3

**Description**

TECHNICAL FIELD

This invention relates to a semiconductor substrate comprising silicon (Si) and silicon carbide (SiC), and a semiconductor device utilizing such a semiconductor substrate. The invention relates more particularly to a semiconductor device having a high dielectric strength and a large current-carrying capacity which is suitable for a high power use.

BACKGROUND ART

Conventional semiconductor devices such as MOS (Metal Oxide Silicon) and bipolar transistors typically have a layered structure formed on a silicon substrate in which impurities are doped.

A dielectric strength of such semiconductor devices is restricted by a degree of a breakdown occurrence and so forth of a silicon layer serving as an output current path. A current-carrying capacity is restricted by a degree of a temperature rise and so forth of the devices, which degrades the characteristics of the devices.

In view of the above, prior arts have employed as a means for increasing a dielectric strength of semiconductor devices such a construction that a thickness of a silicon layer is increased, and as a means for increasing a current-carrying capacity such a construction that the amount of heat release is increased structurally. In addition, in the cases where a further higher voltage and higher current are required, such a construction has been conventionally employed that a temperature increase is suppressed by connecting a large number of semiconductor devices in series or parallel, or by providing an additional devices such as an air cooling fin or a water cooling device.

However, such a large number of semiconductor devices or large scale cooling devices cause an increase in the size and complexity of equipment employing the devices, and also adds the manufacturing cost. In addition, even employing such constructions, the dielectric strength and current-carrying capacity of the semiconductor device cannot be easily improved on a substantial scale. In particular, if the thickness of the silicon layer is increased in order to obtain a higher dielectric strength, the amount of heat release tends to degrade and an ON resistance is increased. Therefore, losses are increased, and a further increase of the heat radiation is induced.

As one of the well-known examples of such semiconductor devices that are intended to increase the amount of heat release, Japanese Unexamined Patent Publication No. 59-27544 discloses a device in which a silicon layer is formed on an insulated base substrate produced by sintering a silicon carbide including a beryllium oxide and the like. However, such a silicon layer formed on a sintered base substrate is a polycrystalline material, and therefore a complicated manufacturing step such as heating by a laser beam is required in order to enlarge a crystal grain. Furthermore, even though such a sintered base substrate of silicon carbide is employed, the silicon carbide substrate is merely an insulator plate for heat releasing, and it does not at all contribute to the improvement in a dielectric strength or reduction of an ON resistance.

In view of the above problems, it is an object of the present invention to provide a semiconductor device with a high dielectric strength and a current-carrying capacity.

It is another object of the present invention to provide a semiconductor substrate capable of forming such a semiconductor device thereon.

DISCLOSURE OF THE INVENTION

The present invention is intended to provide a solution to the above problems. In order to achieve the above and other objects, there is provided in accordance with the present invention a semiconductor substrate comprising a silicon thin film having a crystal grown on a surface of an electrically conductive silicon carbide crystal.

According to the above construction, a depletion layer, which relates to a dielectric strength, is spread to the side of silicon carbide, and therefore a semiconductor substrate having a high dielectric strength can be attained. Furthermore, a heat generated by an electric current flowing in an output current path is efficiently released through the silicon carbide because of its large thermal conductivity, and a semiconductor substrate with a low temperature rise can be therefore attained. Accordingly, it is made possible to produce such a semiconductor device as a transistor for a high power use having a high dielectric strength and current-carrying capacity and the like devices.

The present invention may also be characterized in that the above-mentioned silicon carbide is composed of a single crystal, and the above-mentioned silicon thin film is a single crystal thin film heteroepitaxially grown on a surface of the silicon carbide crystal.

Such a silicon carbide and single crystal thin film of silicon have a desirable crystal structure and a steep interface therebetween, and they can be suitably used for an electrically active member that constitutes an electric current path of a semiconductor device and the like. It is noted that the above-mentioned silicon carbide and single crystal thin film of silicon are not necessarily the ones having a perfect crystal structure over the whole region thereof. In other words, as in the case of usual single crystals, even if a few lattice defects are contained in the silicon thin film or on the interfaces thereof, such silicon carbide and single crystal thin film of silicon are acceptable as far as they substantially retain a crystal condition having such an electrical conductivity that it is clearly distinguished from that of amorphous material or polycrystals.

The present inventors have made intensive studies on means for facilitating a crystal growth of such a silicon thin film as described above, and as a result found the use of a certain crystal structure and surface of a silicon carbide crystal can attain such objects. More specifically, a crystal growth of a silicon thin film is facilitated in the cases where the silicon carbide crystal is 3C-SiC and a surface of the silicon carbide crystal is a (001) face or {111} face, or where the silicon carbide crystal is α-SiC and a surface of the silicon carbide crystal is a {0001} face.

It is noted that, among various types of silicon carbides which show various polytypes, 3C-SiC is the one having a cubic crystal structure ("C" indicates a cubic crystal), and it is also known as β-SiC. α-SiC is the ones having a crystal structure which is not a crystal structure of β-SiC, and includes the ones with crystal structures such as 4H, 6H, 15R and the like ("H") means a hexagonal crystal structure, and "R" means a rhombohedral crystal structure.).

In addition, a heteroepitaxial growth of the silicon thin film is further facilitated when a surface of the silicon carbide crystal is an off-cut surface of a (001) face, {111} face, or {0001} face, and either a width of the terrace is at least 1 nm or the off-cut surface is inclined not less than 0.05° and not more than 10° with respect to each of the above-mentioned faces. If the width of the terrace is smaller or an off-angle with respect to the crystal orientations is larger than 10°, the silicon results in a polycrystal containing crystal grains each with a different crystal orientation, and is likely to cause such a problem that the transfer of electrons in a grain boundary is hindered.

In addition, a silicon carbide crystal formed on a surface of a silicon crystal may be employed as the silicon carbide crystal for the present invention. It is relatively easy to form a silicon carbide crystal on the surface of a silicon crystal, and such a silicon carbide crystal is easily obtained as a commercially available form.

In accordance with the present invention, there is also provided a semiconductor device comprising a crystal of a silicon thin film is grown on a surface of an electrically conductive silicon carbide crystal, the semiconductor device in which the silicon carbide crystal is provided in a output current path. More specifically, the semiconductor device is so constructed that the silicon thin film is disposed between a source electrode or emitter electrode and a drain electrode or collector electrode.

According to the above construction, a high dielectric strength is attained since, in the case of the semiconductor device being an OFF state, an electric field caused by an applied voltage to the semiconductor device acts mainly on the silicon carbide, which has a higher dielectric strength than silicon. Moreover, a heat generated in the case of the semiconductor device being an ON state is released through the silicon carbide, which has a large thermal conductivity, and the temperature rise is therefore suppressed, enabling a large current to be carried in the device. On the other hand, in the case where a dielectric strength of the device is made to be an equal degree to prior art semiconductor devices employing silicon, a thickness of the silicon carbide can be made smaller. As a result, an output current path is made shorter, and thus an ON resistance is reduced. In addition, efficiency in heat release is further improved, and the temperature rise of the semiconductor device is further suppressed by the reduction of the amount of heat generation due to the reduction of losses. Accordingly, a further increase of a current-carrying capacity can be achieved.

BRIEF DESCRIPTION OF THE DRAWINGS

Fig. 1 is a cross sectional view showing a construction of a semiconductor substrate in accordance with Example 1.
Fig. 2 is a cross sectional view showing a construction of a semiconductor substrate in accordance with Example 2.
Fig. 3 is a cross sectional view showing a construction of a semiconductor substrate in accordance with Example 3.
Fig. 4 is a cross sectional view showing a construction of a semiconductor substrate in accordance with Example 4.
Fig. 5 is a cross sectional view showing a construction of a semiconductor substrate in accordance with Example 5.

BEST MODE FOR CARRYING OUT THE INVENTION

Now, the present invention is detailed on the basis of the examples hereinafter.

**Example 1**

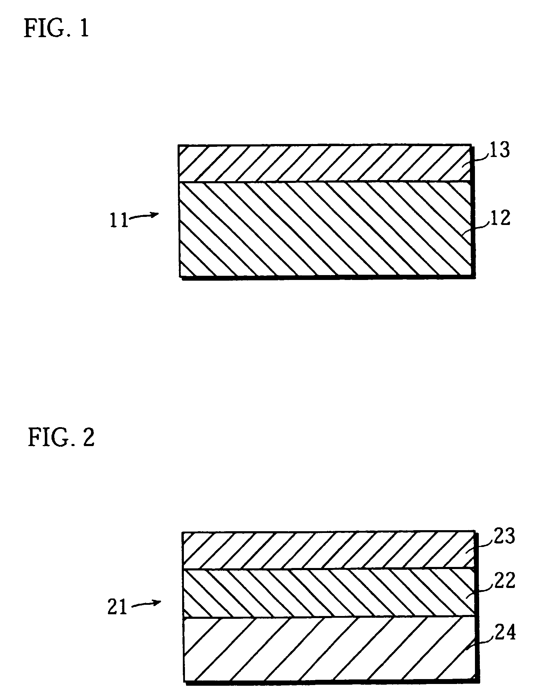

As shown in Fig. 1, a semiconductor substrate 11 in accordance with Example 1 comprises a silicon (Si) thin film 13 grown on a surface of a silicon carbide (SiC) substrate 12.

The SiC substrate 12 is composed of a single crystal of 6H-SiC, and the surface thereof is so formed that it becomes a 4° off-cut surface of a (0001) face. Likewise, the Si thin film 13 also has the same off-cut surface, and a single crystal capable of forming a MOS transistor and the like device is formed.

Such a semiconductor substrate 11 can be manufactured according to the following manner.

(1) Firstly, a surface of the SiC substrate 12, composed of a single crystal of 6H-SiC having a 4° off-cut surface of a (0001) face, is cleaned, and then the substrate 12 is introduced into an MBE growing chamber.

(2) Then, the SiC substrate 12 is heated at approximately 800 °C with a vacuum of approximately $10^{-8}$ Torr, and at the same time, Si is supplied from k-cell. Thereby the Si thin film 13 is heteroepitaxially grown.

The heteroepitaxial growth of Si thin film 13 may be carried out by heating the substrate to the same temperature as above and supplying silane with the use of a CVD apparatus.

The SiC substrate 12 is not limited to the one having an off-cut surface as described above, and the Si thin film 13 may be grown if the substrate 12 has a (0001) face or (000$\bar{1}$) face ({0001} face). However, when the substrate 12 has an off-cut surface of these faces, the crystal growth is further facilitated. More specifically, the crystal growth is particularly facilitated in the case where the SiC substrate 12 has such an off-cut surface that a width of the terrace is not less than 1 nm, or an inclination with regard to the above crystal orientation is not less than 0.05° and not more than 10°.

In addition, the SiC is not limited to 6H-SiC, but other polymorphous SiCs, for example, $\alpha$-SiCs such as 4H-SiC having a {0001} face and the like, and 3C-SiC having a (001) face or {111} face may also be employed. In these cases too, the crystal growth is particularly facilitated when the off-cut surfaces as described above are employed. In the cases of the off-cut surfaces being employed, a resulting Si thin film 13 also retains the same off-cut surface.

**Example 2**

A semiconductor substrate 21 in accordance with Example 2 is composed of an SiC layer 22 and an Si thin film 23 both grown on a surface of an Si substrate 24. The Si substrate 24 is composed of a wafer of single crystal Si and so formed that a surface thereof becomes a (001) face. Likewise, the SiC layer 22 and the Si thin film 23 are also composed of a single crystal having the same crystal structure (3C-SiC and Si both having a (001) face).

Such a semiconductor substrate 21 can be manufactured according to the following manner.

(1) Firstly, a surface of the Si substrate 24, composed of a single crystal Si having a (001) face, is cleaned, and the substrate 24 is introduced into an MBE growing chamber.

(2) Secondly, carbon (C) is supplied from an electron beam evaporation apparatus, and at the same time the Si substrate 24 is heated at approximately 1000 °C with a vacuum of approximately $10^{-8}$ Torr. After the temperature of the Si substrate 24 reaches 1000 °C, Si is supplied from k-cell, and thereby the SiC layer 22 of 3C-SiC having the same (001) face as the Si substrate is heteroepitaxially grown.

(3) Then, according to the same manner as in the above Example 1, the Si thin film 23 is heteroepitaxially grown on the surface of the SiC layer 22.

It is noted that, as in the SiC substrate 12 of Example 1, the crystal growth is further facilitated in the case where the Si substrate 24 has an off-cut surface in which a width of the terrace is not less than 1 nm, or an inclination with regard to the above crystal orientation is not less than 0.5° and not more than 10°. In this case, the resulting SiC layer 22 and Si thin film 23 also has the same off-cut surface as the substrate 24.

The epitaxial growth of the SiC layer 22 and Si thin film 23 is also possible by using a substrate having a {111} face as the Si substrate 24. In the case of the {111} face as well, the crystal growth is further facilitated when the substrate having the same off-cut surface as above is employed.

**Example 3**

Now, the description explains an example of a vertical type MOS transistor utilizing a semiconductor substrate 11 in accordance with the above Example 1.

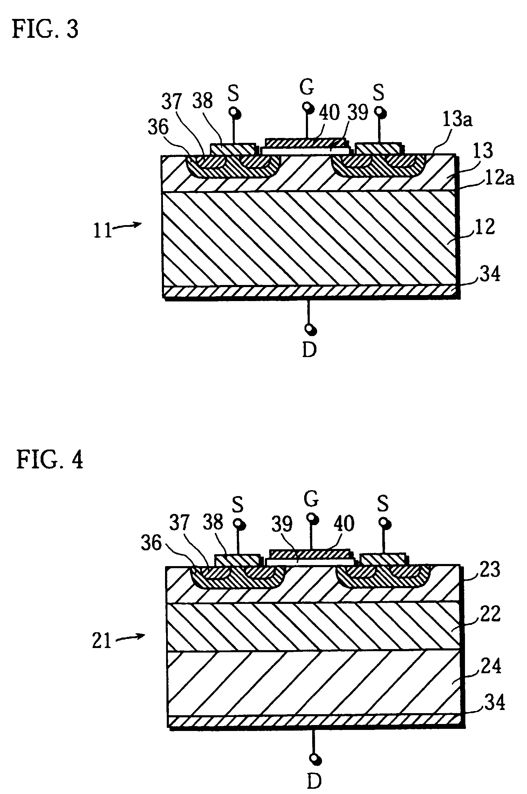

As shown in Fig. 3, a semiconductor substrate 11 employed for this MOS transistor is such a construction that a crystal of a single crystal Si thin film 13 is grown on a surface 12a of an SiC substrate 12 having a disc like shape. The thickness of the Si thin film 13 is 10 μm, and the thickness of the SiC substrate 12 is 300 μm. In the above-mentioned SiC substrate 12, nitrogen (N) is doped as a dopant with a doping level of $10^{18}$, and the substrate 12 is thus formed as an n type 6H-SiC. The Si thin film 13 is formed as an n$^-$ type, in which phosphorus (P) is doped as a dopant with a doping level of $10^{17}$ by supplying phosphine during the crystal growth.

In the Si thin film 13, a donut-shaped p type layer 36 in which boron is doped is formed at a depth of 5 μm from the surface 13a of the Si thin film 13. In this p type layer 36, an n$^+$ layer 37 is also formed by ions implantation of phosphor (P) and the like.

Above the n$^+$ layer 37, a source electrode 38 composed of poly-silicon is provided which makes an ohmic contact with the n$^+$ layer 37. Above a portion in the vicinity of a central portion of the Si thin film 13, i.e., above a portion in the vicinity of an internal circumference of the p type layer 36, a gate electrode 40 composed of aluminum (Al) is provided with a silicon oxide film 39 interposed therebetween. In other words, a gate portion that mainly serves to carry out switching is formed on the Si thin film layer 13 with the silicon oxide film 39 interposed therebetween. On the other side of the SiC substrate 12, there is formed a drain electrode 34 composed of an ohmic electrode made of nickel (Ni).

In a MOS transistor constructed according to the above manner, an electrical conduction between the source electrode 38 and the drain electrode 34 is controlled corresponding to a voltage applied to the gate electrode 40.

To be more specific, in the case of an OFF state, a depletion layer spreads from the n⁻ type Si thin film 13 to the SiC substrate 12, and thereby a gap between the source electrode 38 and the drain electrode 34 a becomes a non-conductive state. In this condition, electric field is mainly supplied to the SiC substrate 12, and therefore a dielectric strength of the MOS transistor is mostly determined by the SiC, which has a higher dielectric strength than Si. In fact, it was confirmed that this MOS transistor exhibited a dielectric strength of over 1000 V. A conventional MOS transistor which employs an n⁻ type Si substrate with the same thickness as the SiC substrate 12 (300 μm) shows a dielectric strength of 500 V. From the result, it is understood that the MOS transistor according to this example achieves a far higher dielectric strength than conventional MOS transistors.

On the other hand, in the case of an ON state, a gap between the source electrode 38 and the drain electrode 34 becomes a conductive state m which an electric current flows via the n⁺ layer 37, the Si thin film 13, and the SiC substrate 12. In this condition, heat is generated in the MOS transistor by the electric current flowing therein, but the generated heat is efficiently released through the SiC substrate 12. This is due to the fact that SiC has a large thermal conductivity, and that a contact surface of the SiC substrate 12 and the Si thin film 13 formed by a crystal growth on the surface of the SiC substrate 12 has a large heat transfer coefficient. Accordingly, in comparison with a MOS transistor employing an Si substrate having the same size, the temperature rise of the MOS transistor in accordance with this example is suppressed at the same degree even when 1.8 times larger electric current is applied.

Conversely, if the dielectric strength of the MOS transistor according to this example is made to have a dielectric strength of 500 V, which is the same value as that of a MOS transistor employing an Si substrate with a thickness of 300 μm, it is made possible to make the thickness of the SiC substrate to be as thin as approximately 100 μm or less. In this condition, the output current path is shortened, and therefore, the ON resistance is reduced to be 70 % or less. Furthermore, the temperature rise of the MOS transistor is further suppressed because of the further improvement in the heat release efficiency and the reduction of the amount of the generated heat achieved by a loss reduction.

**Example 4**

In place of the semiconductor substrate 11 in the MOS transistor of the above Example 3, the semiconductor substrate 21 of Example 2 can be employed, as shown in Fig. 4. The same reference characters are used for the parts having the same functions as in the above Example 2 and 3, and the explanations for the corresponding parts are therefore omitted.

In the case of this construction as well, the SiC layer 22 is disposed in the output current path (between the source electrode 38 and the drain electrode 34). Therefore, the dielectric strength is increased, and in addition, a high efficiency in heat release is achieved and the temperature rise is suppressed due to a large thermal conductivity of the SiC layer. Hence, it is made possible to apply a large current.

**Example 5**

There is now explained another example of a MOS transistor employing the semiconductor substrate 11 of the above Example 1. In this Example 5, The same reference characters are used for the parts having the same functions as in the above Example 1 and 3, and the explanations for the corresponding parts are therefore omitted.

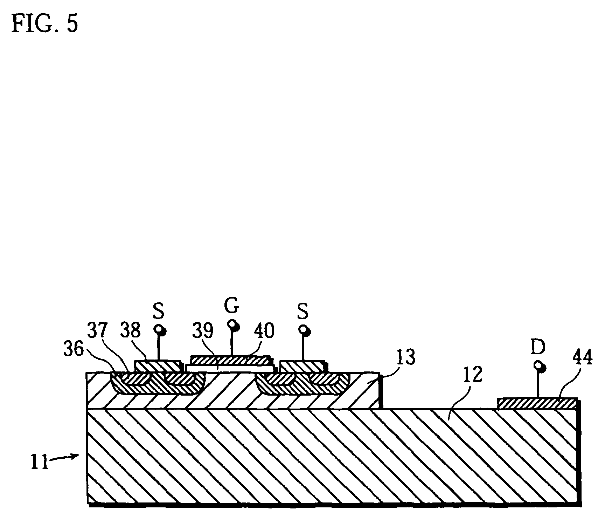

As shown in Fig. 5, in this MOS transistor, part of the Si thin film 13 is removed, and a drain electrode 44 is provided on the exposed part of the SiC substrate 12. The removal of the Si thin film 13 can be carried out by, for example, a plasma etching using oxygen and flon gas. It is noted here that if the Si thin film 13 is not completely removed and thereby a little Si thin film 13 is present between the SiC substrate 12 and the gate electrode 44, the formation of the MOS transistor is possible.

In the case of this construction as well, a high dielectric strength and a suppression of the temperature rise are achieved, and thereby it is made possible to apply a large current.

It is noted that in the above Examples 3 to 5, although MOS transistors are formed by using the semiconductor substrate 11 and 21, in the cases of forming bipolar transistors as well, the improvement of dielectric strength and increase of current-carrying capacity can be achieved by employing such construction that SiC is disposed in the output current path.

INDUSTRIAL APPLICABILITY

As has been described thus far, according to the present invention, a semiconductor substrate comprising a crystal of a silicon thin film is grown on a surface of electrically conductive silicon carbide crystal, and the silicon carbide crystal is provided in an output current path of a semiconductor device. Therefore, it is made possible to obtain a semiconductor device with a high dielectric strength and a large current-carrying capacity, and a semiconductor substrate capable of forming such a semiconductor device thereon. Hence, the present invention is useful in such application fields that a control and signal processing with a large electric power are required.

**Claims**

1.  A semiconductor substrate comprising a silicon thin film having a crystal grown on a surface of an electrically conductive silicon carbide crystal.

2.  A semiconductor substrate according to claim 1, in which said silicon carbide is composed of a single crystal and said silicon thin film is composed of a single crystal thin film heteroepitaxially grown on a surface of said silicon carbide crystal.

3.  A semiconductor substrate according to claim 1, in which said silicon carbide crystal is 3C-SiC, and said surface of said silicon carbide crystal on which said silicon thin film is to be grown is a (001) face.

4.  A semiconductor substrate according to claim 1, in which said silicon carbide crystal is 3C-SiC, said surface of said silicon carbide crystal on which said silicon thin film is to be grown is an off-cut surface of a (001) face, and a width of a (001) terrace on said surface is not less than 1 nm.

5.  A semiconductor substrate according to claim 1, in which said silicon carbide crystal is 3C-SiC, and said surface of said silicon carbide crystal on which said silicon thin film is to be grown is an off-cut surface which is inclined not less than 0.05° and not more than 10° with respect to a (001) face.

6.  A semiconductor substrate according to claim 1, in which said silicon carbide crystal is 3C-SiC, and said surface of said silicon carbide crystal on which said silicon thin film is to be grown is a {111} face.

7.  A semiconductor substrate according to claim 1, in which said silicon carbide crystal is 3C-SiC, said surface of said silicon carbide on which said silicon thin film is to be grown is an off-cut surface of a {111} face, and a width of a {111} terrace on said surface is not less than 1 nm.

8.  A semiconductor substrate according to claim 1, in which said silicon carbide crystal is 3C-SiC, and said surface of said silicon carbide crystal on which said silicon thin film is to be grown is an off-cut surface which is inclined not less than 0.05° and not more than 10° with respect to a {111} face.

9.  A semiconductor substrate according to claim 1, in which said silicon carbide crystal is $\alpha$-SiC, and said surface of said silicon carbide crystal on which said silicon thin film is to be grown is a {0001} face.

10. A semiconductor substrate according to claim 1, in which said silicon carbide crystal is $\alpha$-SiC, said surface of said silicon carbide crystal on which said silicon thin film is to be grown is an off-cut surface of a {0001} face, and a width of a {0001} terrace on said surface is not less than 1 nm.

11. A semiconductor substrate according to claim 1, in which said silicon carbide crystal is $\alpha$-SiC, and said surface of said silicon carbide crystal on which said silicon thin film is to be grown is an off-cut surface which is inclined not less than 0.05° and not more than 10° with respect to a {0001} face.

12. A semiconductor substrate according to claim 1, in which said silicon carbide crystal is formed on a surface of a silicon crystal.

13. A semiconductor device comprising a silicon thin film having a crystal grown on a surface of an electrically conductive silicon carbide crystal, in which said silicon carbide crystal is provided in an output current path.

14. A semiconductor device according to claim 13, in which said semiconductor device is a field effect type semiconductor device in which a source electrode is provided on a side of said silicon thin film in said output current path, and a gate electrode is provided on a side of said silicon carbide crystal in said output current path.

15. A semiconductor device according to claim 13, in which said semiconductor device is a bipolar type semiconductor device in which an emitter electrode is provided on a side of said silicon thin film in said output current path, and a collector electrode is provided on a side of a silicon carbide crystal in said output current path.

FIG. 1

FIG. 2

FIG. 3

FIG. 4

FIG. 5

# INTERNATIONAL SEARCH REPORT

International application No.

PCT/JP98/03577

**A. CLASSIFICATION OF SUBJECT MATTER**

Int.Cl⁶ H01L21/20, H01L21/203, H01L21/205, H01L21/336, H01L29/73, H01L29/78

According to International Patent Classification (IPC) or to both national classification and IPC

**B. FIELDS SEARCHED**

Minimum documentation searched (classification system followed by classification symbols)

Int.Cl⁶ H01L21/20, H01L21/203, H01L21/205, H01L21/336, H01L29/73, H01L29/78

Documentation searched other than minimum documentation to the extent that such documents are included in the fields searched

Jitsuyo Shinan Koho 1960-1998
Kokai Jitsuyo Shinan Koho 1971-1998

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP, 09-172159, A (International Rectifier Corp.), 30 June, 1997 (30. 06. 97), Fig. 1 & GB, 230625, A & DE, 19641839, A1 & FR, 274097, A1 & TW, 317647, A & KR, 97024296, A | 1, 2, 12-14<br>1-14 |
| X | JP, 63-19869, A (Fujitsu Ltd.), 27 January, 1988 (27. 01. 88), Fig. 1 (Family: none) | 1, 2, 15 |
| X | JP, 02-3931, A (Fujitsu Ltd.), 9 January, 1990 (09. 01. 90), Fig. 1 (Family: none) | 1, 2, 15 |
| Y | JP, 08-51110, A (Matsushita Electric Industrial Co., Ltd.), 20 February, 1996 (20. 02. 96), Page 3, right column, lines 4 to 17 (Family: none) | 9, 10, 11 |

☒ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | | |
| | | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 2 December, 1998 (02. 12. 98) | 15 December, 1998 (15. 12. 98) |

| Name and mailing address of the ISA/ | Authorized officer |
|---|---|
| Japanese Patent Office | |
| Facsimile No. | Telephone No. |

Form PCT/ISA/210 (second sheet) (July 1992)

INTERNATIONAL SEARCH REPORT

International application No.

PCT/JP98/03577

C (Continuation).   DOCUMENTS CONSIDERED TO BE RELEVANT

| Category* | Citation of document, with indication, where appropriate, of the relevant passages | Relevant to claim No. |
|---|---|---|
| Y | JP, 09-181355, A  (Matsushita Electric Industrial Co., Ltd.), 11 July, 1997 (11. 07. 97), Page 5, left column, lines 11 to 14  (Family: none) | 3-8 |
| A | JP, 62-216217, A  (Fujitsu Ltd.), 22 September, 1987 (22. 09. 87), Page 2, lower left column, line 14 to lower right column, line 19  (Family: none) | 3-8 |
| A | JP, 09-82643, A  (Matsushita Electric Industrial Co., Ltd.), 28 March, 1997 (28. 03. 97), Fig. 2  (Family: none) | 3-8 |

Form PCT/ISA/210 (continuation of second sheet) (July 1992)